# EUROPÄISCHE PATENTSCHRIFT

(11) **EP 1 704 603 B1**
(45) Veröffentlichungstag und Bekanntmachung des Hinweises auf die Patenterteilung: **30.12.2009**
(21) Anmeldenummer: 05701499.5
(22) Anmeldetag: 12.01.2005
(51) Int. Cl.: H01L 41/24

(54) **VERFAHREN ZUM HERSTELLEN EINER KORRELATION ZWISCHEN EINEM ERSTEN ZUSTAND EINES PIEZOELEKTRISCHEN BAUTEILS UND EINEM ZWEITEN ZUSTAND DES BAUTEILS SOWIE VERWENDUNG DER KORRELATION**
METHOD FOR PRODUCING A CORRELATION BETWEEN A FIRST STATE AND A SECOND STATE OF A PIEZOELECTRIC COMPONENT, AND THE USE OF SAID CORRELATION
PROCEDE D'ETABLISSEMENT D'UNE CORRELATION ENTRE UN PREMIER ETAT ET UN SECOND ETAT D'UN COMPOSANT PIEZO-ELECTRIQUE, ET UTILISATION DE LADITE CORRELATION

(30) Priorität: 12.01.2004 DE 102004001696
(43) Veröffentlichungstag der Anmeldung: 27.09.2006
(73) Patentinhaber: Continental Automotive GmbH, 30165 Hannover (DE)
(72) Erfinder: LUBITZ, Karl, 85521 Ottobrunn (DE); SCHUH, Carsten, 85598 Baldham (DE); WOLFF, Andreas, 81825 München (DE)
(86) Internationale Anmeldenummer: PCT/EP2005/050111
(87) Internationale Veröffentlichungsnummer: WO 2005/067069

(56) Entgegenhaltungen:
- DE-A1- 10 104 604
- US-A- 4 088 917
- US-A- 5 308 462
- US-A- 6 046 526
- US-B1- 6 464 925

## Beschreibung

Die Erfindung betrifft ein Verfahren zum Herstellen einer Korrelation zwischen einem ersten Zustand eines piezoelektrischen Bauteils, das eine Piezokeramik aufweist, und einem zweiten Zustand des Bauteils. Daneben wird eine Verwendung der Korrelation angegeben.

Die Patentschriften US6046526 und US6464925 sind Beispiele aus dem stand der Technik.

Das piezoelektrische Bauteil ist beispielsweise ein piezoelektrischer Aktor mit einem monolithischen Aktorkörper. Der Aktorkörper besteht beispielsweise aus einer Vielzahl von in einer Stapelrichtung übereinander angeordneten Piezoelementen. Ein einzelnes Piezoelement weist mindestens zwei übereinander angeordnete Elektrodenschichten und mindestens eine zwischen den Elektrodenschichten angeordnete piezoelektrische Schicht mit der Piezokeramik (Piezokeramikschicht) auf. Die Piezoelemente sind so angeordnet, dass Elektrodenschichten und piezoelektrische Schichten abwechselnd übereinander angeordnet sind. Jede der Elektrodenschichten, die als Innenelektroden bezeichnet werden, fungiert als Elektrodenschicht benachbarter Piezoelemente. Zur elektrischen Kontaktierung der Elektrodenschichten sind benachbarte Elektrodenschichten abwechselnd an zwei elektrisch voneinander isolierte, seitliche Oberflächenabschnitte des Aktorkörpers geführt. An diesen Oberflächenabschnitten weist der Aktorkörper jeweils eine streifenförmige Metallisierung auf.

Ein piezoelektrisch aktiver Bereich der Piezokeramikschicht befindet sich zwischen den Elektrodenschichten des jeweiligen Piezoelements. In diesem Bereich der Piezokeramikschicht wird durch eine elektrische Ansteuerung der Elektroden ein relativ homogenes elektrisches Feld induziert. Über den gesamten piezoelektrisch aktiven Bereich hinweg kommt es zu einer homogenen Auslenkung der Piezokeramikschicht. Dagegen ist jede Piezokeramikschicht im Bereich der beschriebenen Oberflächenabschnitte piezoelektrisch inaktiv. Aufgrund der abwechselnden Führung der Elektrodenschichten an die Oberflächenabschnitte wird in den piezoelektrisch inaktiven Bereich der Piezokeramikschicht ein elektrisches Feld eingekoppelt, das sich deutlich von dem elektrischen Feld unterscheidet, das in den piezoelektrisch aktiven Bereich der Piezokeramikschicht eingekoppelt wird. Bei der elektrischen Ansteuerung der Elektrodenschichten, also beim Polarisieren und/oder im Betrieb des Piezoaktors, kommt es aufgrund der unterschiedlichen elektrischen (Polarisations-)Felder zu unterschiedlichen Auslenkungen der Piezokeramikschicht im piezoelektrisch aktiven Bereich und im piezoelektrisch inaktiven Bereich. Als Folge davon treten mechanische Spannungen im Piezoelement auf, die zu einem sogenannten Polungsriss quer zur Stapelrichtung führen können. Dieser Polungsriss kann sich in die an den Oberflächenabschnitten des Aktorkörpers angebrachten Metallisierungen fortsetzen. Dies führt zu einem Unterbrechen der elektrischen Kontaktierung zumindest eines Teils der Elektrodenschichten des Aktorkörpers.

Um die Wahrscheinlichkeit für das Auftreten von Polungsrissen schon während des Polarisierens eines monolithischen Aktorkörpers zu verringern, wird in der DE 197 56 182 C2 für den oben beschriebenen Piezoaktor ein spezielles Polarisierungsverfahren angegeben. Der Aktorkörper besteht aus mehreren hundert, abwechselnd angeordneten Piezokeramikschichten und Elektrodenschichten. Die Piezokeramikschichten sind aus einem Bleizirkonattitanat (PZT). Die Elektrodenschichten sind aus einer Silber-Palladium-Legierung. Zum Herstellen des Aktorkörpers werden keramische Grünfolien mit einer Silber-Palladium-Paste bedruckt, übereinander gestapelt, entbindert und gemeinsam gesintert.

Gemäß dem Polarisierungsverfahren wird während des Anlegens eines Polarisationsfeldes eine mechanische Druckspannung am Aktorkörper angelegt, die einer verlängernden Wirkung des Polarisationsfeldes entgegenwirkt. Dadurch wird ein Ausmaß der Ausdehnungsänderung der Piezokeramikschicht im piezoelektrisch aktiven Bereich verringert. Es kommt zu geringeren mechanischen Spannungen im Aktorkörper. Mit dem beschriebenen Verfahren lässt sich somit die Wahrscheinlichkeit für das Auftreten von Polungsrissen im Aktorkörper verringern.

Das Polen des Aktorkörpers ist aber nur ein Arbeitsschritt von vielen Arbeitsschritten, die notwendig sind, um einen Piezoaktor zu erhalten, der für entsprechende Anwendungen geeignet ist. Eine Anwendung des Piezoaktors ist beispielsweise eine Ansteuerung eines Einspritzventils eines Motors eines Kraftfahrzeugs. Die weiteren Arbeitsschritte werden vor oder nach dem Polarisieren durchgeführt. So werden beispielsweise elektrische Anschlusselemente an den Metallisierungsstreifen angebracht. Der Aktorkörper wird üblicherweise auch mit einer Kunststoffmasse vergossen. Dadurch wird die Oberfläche des Aktorkörpers vor mechanischer Zerstörung oder vor elektrischen Überschlägen zwischen benachbarten Elektrodenschichten geschützt. Darüber hinaus wird der Aktorkörper nicht nur unter einer mechanischen Druckspannung gepolt, sondern auch unter einer mechanischen Druckspannung betrieben. Dies bedeutet, dass der Aktorkörper vorgespannt wird. Dazu wird beispielsweise der (mit Kunststoff vergossene) Aktorkörper in eine Rohrfeder eingeschweißt.

Am Ende der beschriebenen Herstellungskette ist zu überprüfen, ob der Piezoaktor bestimmungsgemäß eingesetzt werden kann. Es muss die Qualität des Piezoaktors ermittelt werden. Die Qualität betrifft insbesondere piezoelektrische Kenngrößen des Piezoaktors, beispielsweise dessen d₃₃-Koeffizienten. Dabei stellt sich oftmals heraus, dass der hergestellte Piezoaktor piezoelektrische Kenngrößen aufweist, die die Verwendung des Piezoaktors ausschließen. Der Ausschluss ist dabei häufig auf Defekte zurückzuführen, die bereits durch die Sinterung induziert werden.

Aufgabe der Erfindung ist es daher, aufzuzeigen, wie bereits nach dem Sintern des Aktorkörpers eine Aussage über eine Qualität des Aktorkörpers getroffen werden kann.

Zur Lösung der Aufgabe wird ein Verfahren gemäß Anspruch 1 zum Herstellen einer Korrelation zwischen einem ersten Zustand eines piezoelektrischen Bauteils, das eine Piezokeramik aufweist, und einem zweiten Zustand des Bauteils angegeben, wobei der zweite Zustand des Bauteils aus dem ersten Zustand des Bauteils durch ein Polarisieren der Piezokeramik des Bauteils erzeugt wird. Das Verfahren weist folgende Verfahrensschritte auf: a) Bereitstellen einer ersten Gruppe von Bauteilen mit jeweils dem ersten Zustand, b)Ermitteln mindestens einer bestimmten Eigenschaft jedes der Bauteile der ersten Gruppe, c) Polarisieren der Piezokeramik der Bauteile der ersten Gruppe, wobei aus jedem der Bauteile der ersten Gruppe ein entsprechendes Bauteil einer zweiten Gruppe entsteht, das den zweiten Zustand aufweist, d) Ermitteln mindestens einer bestimmten Eigenschaft jedes der Bauteile der zweiten Gruppe und e) Herstellen der Korrelation durch Vergleich der bestimmten Eigenschaften jedes der Bauteile der ersten Gruppe und der bestimmten Eigenschaft des entsprechenden Bauteils der zweiten Gruppe.

Gemäß einem zweiten Aspekt der Erfindung wird die hergestellte Korrelation zur Vorhersage der bestimmten Eigenschaft eines bestimmten piezoelektrischen Bauteils mit dem zweiten Zustand aus der ermittelten Eigenschaft des bestimmten Bauteils mit dem ersten Zustand verwendet.

Als piezoelektrisches Bauteil kommt jedes beliebige piezoelektrische Bauteil in Frage, das im Hinblick auf seinen Einsatz gepolt wird. Die Piezokeramik des Bauteils wird polarisiert. Durch das Polen des Bauteils bzw. durch das Polarisieren der Piezokeramik wird ein für den Betrieb des Bauteils geeigneter (Polungs-)Zustand erzeugt. Dieser Zustand ist der zweite Zustand des Bauteils.

Das piezoelektrische Bauteil ist beispielsweise ein piezoelektrischer Biegewandler. Der Biegewandler weist ein Piezoelement oder mehrere geeignet zueinander angeordnete Piezoelemente auf. Das piezoelektrische Bauteil ist insbesondere ein eingangs beschriebener Piezoaktor mit einem Aktorkörper in monolithischer Vielschichtbauweise. Denkbar ist aber auch ein Aktorkörper, bei dem die einzelnen Piezoelemente nicht monolithisch miteinander verbunden sind. Beispielsweise sind die Piezoelemente miteinander verklebt.

Die grundlegende Idee der Erfindung besteht darin, einen empirischen Zusammenhang (Korrelation) zwischen dem (Ausgangs-)Zustand des Bauteils vor dem Polarisieren der Piezokeramik und dem (Polungs-)Zustand des Bauteils nach dem Polarisieren der Piezokeramik herzustellen. Dazu werden geeignete Eigenschaften (z.B. physikalische Kenngrößen oder chemische Zusammensetzung) einer Vielzahl der Bauteile vor dem Polarisieren bestimmt, anschließend jedes der Bauteile gepolt und nachfolgend die Eigenschaften (z.B. piezoelektrische Kenngrößen) der Bauteile nach dem Polen bestimmt. Durch Vergleich der Eigenschaften der Bauteile im Ausgangszustand mit den Eigenschaften des jeweiligen Bauteils im Polungszustand wird die Korrelation ermittelt. Bei Kenntnis der Korrelation können aufgrund der Eigenschaften eines bestimmten Bauteils, das sich im Ausgangszustand befindet, von vornherein die nach dem Polen zu erwartenden Eigenschaften des Bauteils abgeschätzt werden. Es kann mit einer gewissen Wahrscheinlichkeit auf die Eigenschaften des nach dem Polarisieren der Piezokeramik erhaltenen Bauteils geschlossen werden. Somit ist es möglich, eine Vorauswahl für die Weiterbehandlung der Bauteile zu treffen. Bauteile, deren zu erwartenden Eigenschaften nicht innerhalb eines festzulegenden Toleranzbereichs liegen, werden verworfen und nicht weiter verarbeitet. Liegen die aufgrund der empirisch ermittelten Korrelation zu erwartenden Eigenschaften innerhalb des Toleranzbereichs, wird das Bauteil zur Weiterverarbeitung freigegeben. Mit der beschriebenen Vorgehensweise ist es möglich, eine Qualitätssicherung schon in einem relativ frühen Stadium der Herstellung des piezoelektrischen Bauteils durchzuführen.

Gemäß der Erfindung wird eine Anzahl von bestimmten Eigenschaften des Bauteils mit dem ersten Zustand ermittelt und zum Herstellen der Korrelation mit der bestimmten Eigenschaft des Bauteils mit dem zweiten Zustand verwendet. Dies bedeutet, dass mehr als eine einzige Eigenschaft des Bauteils im ersten Zustand bestimmt wird, um auf die Eigenschaft oder die Eigenschaften des Bauteils im zweiten Zustand zu schließen. Durch das Ermitteln mehrerer Eigenschaften des Bauteils im Zustand vor dem Polarisieren kann eine Zuverlässigkeit der Vorhersage über die Eigenschaften des Bauteil im Zustand nach dem Polarisieren erhöht werden. Dies trägt zur Sicherheit bezüglich der Vorhersage der Eignung eines Bauteils für eine bestimmte Anwendung bei.

Gemäß der Erfindung wird die bestimmte Eigenschaft des Bauteils mit dem ersten Zustand aus der Gruppe Verlustwinkel (tan δ) der piezoelektrischen Schicht, Isolationswiderstand der piezoelektrischen Schicht, Dichte der piezoelektrischen Schicht, relative Permittivität der piezoelektrischen Schicht, ferroelastisches Verhalten des Bauteils, Elastizitätsmodul (E-Modul) des Bauteils, longitudinale Schallgeschwindigkeit des Bauteils und/oder Temperaturgang der Kapazität des Bauteils ausgewählt. Aus den genannten physikalischen Kenngrößen wird mindestens eine ausgewählt. Wie oben angegeben, werden bevorzugt mehrere der aufgezählten physikalischen Kenngrößen ermittelt, um die Korrelation zwischen den Zuständen des Bauteils herzustellen.

Zur Bestimmung des Elastizitätsmoduls oder der Schallgeschwindigkeit wird das Bauteil beispielsweise mechanisch angeregt. Das ferroelastische Verhalten wird beispielsweise durch eine einmalige Druckbelastung des Bauteils ermittelt. Bei Anlegen einer Druckspannung auf das Bauteil (Druckbelastung des Bauteils) kann eine sogenannte Spannungs-Dehnungskurve erfasst werden. Bei niedrigerer Druckspannung ist die Dehnung des Bauteils linear von der angelegten Druckspannung abhängig. Bei höherer Druckspannung ist die Dehnung von der Druckspannung nicht mehr linear abhängig. Zur Ermittlung des ferroelastischen Verhaltens des Bauteils wird die einmalige Druckbelastung bis in den beschriebenen nicht-linearen Bereich der Spannungs-Dehnungskurve durchgeführt. Das ferroelastische Verhalten ist u.a. gekennzeichnet durch die Druckspannung, bei der eine Abweichung von der Linearität beobachtet wird, und durch die durch die Druckspannung induzierte, verbleibende Längenänderung (Verkürzung) des Bauteils nach der Druckbelastung. Eine weitere Größe ist der sogenannte Koerzitivdruck, also die Druckspannung, die notwendig ist, um ein gepoltes Bauteil wieder zu entpolen.

Die Piezokeramik des Bauteils kann dabei zusammen mit weiteren Materialien einen Verbundwerkstoff bilden. Im Fall eines oben beschriebenen Piezoelements kann beispielsweise die piezoelektrische Schicht aus einer Polymermatrix bestehen, in die Piezokeramik-Partikel eingebettet sind. Vorzugsweise wird aber die piezoelektrische Schicht allein von der Piezokeramik gebildet.

Als Piezokeramik ist jeder beliebige piezokeramische Werkstoff oder eine Mischung aus mehreren piezokeramischen Werkstoffen denkbar. Insbesondere wird als Piezokeramik ein Bleizirkonattitanat (Pb(Ti,Zr)03, PZT) verwendet. Das PZT ist ein Perowskit (ABO₃). Die A-Plätze des Perowskits werden von Blei besetzt. Die B-Plätze des Perowskits werden von Titan und von Zirkonium eingenommen. Das Bleizirkonattitanat kann dabei auch dotiert sein. Beispielsweise verfügt das PZT über Seltenerddotierungen.

Bei Verwendung einer Piezokeramik mit Bleizirkonattitanat wird in einer besonderen Ausgestaltung als bestimmte Eigenschaft des Bauteils mit dem ersten Zustand ein Verhältnis eines rhomboedrischen Volumenanteils mit rhomboedrischer Phase und eines tetragonalen Volumenanteils mit tetragonaler Phase verwendet. Das PZT-Mischkristallsystem (PbZrₓTi₍₁₋ₓ₎O₃) ist durch eine lückenlose Mischbarkeit des Bleizirkonats (PbZrO₃, PZ) und des Bleititanats (PbTiO₃, PT) gekennzeichnet. Bei einer Temperatur über der Curie-Temperatur (T_{C}) kristallisiert das PZT unabhängig von einem Zirkonium-Titan-Verhältnis in einer paraelektrischen, kubischen Perowskitstruktur. Wird die Curie-Temperatur unterschritten, kommt es zu einer spontanen Verzerrung des kubischen Gitters. Dabei bilden sich in Abhängigkeit vom Zirkonium-Titanverhältnis verschiedene Phasen aus. Titanreiche Mischkristalle (0,47 > x > 0) bilden bei Raumtemperatur eine ferroelektrische Mischkristallphase mit tetragonaler Gitterstruktur (tetragonale Phase). Kristallite der tetragonalen Phase zeichnen sich durch 180°- und 90°-Domänen aus. Zirkoniumreiche Mischkristalle (0,47 < x < 1) bilden dagegen bei Raumtemperatur eine ferroelektrische Mischkristallphase mit rhomboedrischer Gitterstruktur (rhomboedrische Phase). Kristallite der rhomboedrischen Phase zeichnet sich 180°-, 71°- und 109°-Domänen aus. Das Zirkonium-Titan-Verhältnis, bei dem beide ferroelektrischen Phasen vorliegen, wird als morphotrope Phasengrenze bezeichnet. Die morphotrope Phasengrenze bezeichnet also einen Koexistenzbereich, in dem die tetragonale Phase und die rhomboedrische Phase nebeneinander existieren.

Es hat sich gezeigt, dass das Verhältnis des Volumenanteils der tetragonalen Phase zum Volumenanteil der rhomboedrischen Phase die piezoelektrischen Eigenschaften des gepolten Bauteils stark beeinflusst. Daraus wird gefolgert, dass bei Kenntnis des Verhältnisses der Volumenanteile mit großer Wahrscheinlichkeit auf die piezoelektrischen Eigenschaften des Bauteils geschlossen werden kann. Es wird überprüft, ob nach dem Sintern die morphotrope Phasengrenze vorliegt. Wenn die morphotrope Phasengrenze vorliegt, so kann mit einer gewissen Wahrscheinlichkeit eine Aussage darüber getroffen werden, ob das später, nach dem Polarisieren erhaltene Bauteil die benötigten piezoelektrischen Kenngrößen aufweist.

Zum Ermitteln der morphotropen Phasengrenze kann auf die Röntgenstrukturanalyse zurückgegriffen werden. Diese Analyse führt allerdings nur zum Verhältnis der Oberflächenanteile der Phasen an der untersuchten Oberfläche des Bauteils. Von dem Verhältnis der Oberflächenanteile kann auf das Verhältnis der Volumenanteile geschlossen werden.

Um den beschriebenen, mit Unsicherheiten behafteten Transfer vom Verhältnis der Oberflächenanteile auf das Verhältnis der Volumenanteile zu umgehen, werden vorzugsweise Kenngrößen ermittelt, die sehr empfindlich auf das Verhältnis der Volumenanteile der beiden Phasen reagiert. Insbesondere wird daher zum Ermitteln der morphotropen Phasengrenze auf die Bestimmung der oben beschriebenen physikalischen Kenngrößen zurückgegriffen. Diese Kenngrößen reagieren sehr empfindlich auf das Verhältnis der Volumenanteile der tetragonalen und der rhomboedrischen Phase der Piezokeramik zueinander. So kann beispielsweise durch die Bestimmung der Dichte (aus Abmessung und Gewicht des Bauteils) das Verhältnis der Volumenanteile bestimmt werden. Je höher die Dichte ist, desto größer ist der Anteil der rhomboedrischen Phase. Auch die Bestimmung der relativen Dielektrizitätskonstante der Piezokeramik aus gemessener Kapazität bei definierter Temperatur (z.B. 20°C) und genau ermittelten Strukturdaten des Bauteils (z.B. Schichtdicken der Piezokeramikschicht und der Elektrodenschichten eines Piezoelements) eignet sich sehr gut zur Bestimmung der morphotropen Phasengrenze. Die weiteren, bereits oben erwähnten Kenngrößen sind Verlustwinkel (tan δ) der piezoelektrischen Schicht, Isolationswiderstand der piezoelektrischen Schicht, ferroelastisches Verhalten des Bauteils, Elastizitätsmodul (E-Modul) des Bauteils, longitudinale Schallgeschwindigkeit des Bauteils und/oder Temperaturgang der Kapazität des Bauteils. Um eine reltiv genaue Aussage über die morphotrope Phasengrenze treffen zu können, werden vorzugsweise mehrere der beschriebenen physikalischen Eigenschaften ermittelt.

Die Eigenschaften des Bauteils werden gewöhnlich nach dem Sintern des Bauteils und vor der Weiterverarbeitung des Bauteils bestimmt. Das Bauteil ist in diesem Zustand nicht gepolt. Die Piezokeramik ist nicht polarisiert. In einer besonderen Ausgestaltung werden aber Bauteile der ersten Gruppe verwendet, deren erster Zustand sich jeweils durch eine teilweise Polarisierung der Piezokeramik auszeichnet. Es werden vorgepolte bzw. schwach gepolte piezokeramische Bauteile verwendet. Vorzugsweise sind die Bauteile derart gepolt, dass keine Vorschädigung des Bauteils auftritt. Ein oben beschriebener Polungsriss in einem Aktorkörper in monolithischer Vielschichtbauweise wäre eine derartige Vorschädigung. Um Polungsrisse im Aktorkörper zu vermeiden, wird die Piezokeramik des Aktorkörpers bis zu einem Grad polarisiert, der weit weg ist von einer Sättigung der Polarisierung. Es wird darauf geachtet, dass im remanenten Zustand, also im bleibend gepolten Zustand, keine Polungsrisse vorhanden sind.

Zur Polarisierung der Piezokeramik der Bauteile wird ein geeignetes Polarisationsfeld erzeugt. So wird beispielsweise ein unipolares Polarisationsfeld mit "Gleich-Feldstärke" verwendet. Dabei kann eine lineare Rampe (zeitliche Erhöhung oder Verringerung der Feldstärke) und/oder Haltezeit der Feldstärke vorgesehen sein. Denkbar ist auch ein Polarisationsfeld mit pulsierendem Gleichfeld. Eine Frequenz eines solchen Polarisationsfeldes ist dabei vorzugsweise so gewählt, dass es zu keiner Erwärmung der Piezokeramik kommt.

Um die Piezokeramik der Bauteile teilweise zu polarisieren, gibt es verschiedene Möglichkeiten. Im Folgenden werden bevorzugte Polarisierungsverfahren bzw. bevorzugte Bedingungen angegeben, unter denen das Polarisierungsverfahren durchgeführt wird. Die Polarisierungsverfahren bzw. die Bedingungen, unter denen die Bauteile vorgepolt werden, sind den Bauteilen entsprechend anzuwenden bzw. miteinander kombinierbar.

Zur teilweisen Polarisierung wird beispielsweise die Piezokeramik der Bauteile bei Raumtemperatur druckfrei polarisiert. Dies bedeutet, dass keine mechanische Druckspannung während des Anlegens des Polarisationsfeldes auf das Bauteil ausgeübt wird. Dabei werden vorwiegend alle 180°-Domänen der Kristallite der tetragonalen Phase und der rhomboedrischen Phase in Feldrichtung geschaltet.

Alternativ dazu wird zur teilweisen Polarisierung die Piezokeramik der Bauteile bei einer Polungstemperatur polarisiert, die höher ist als die Raumtemperatur. Als Raumtemperatur werden etwa 20° C mit einer Abweichung von bis zu ± 10° C angesehen. Dabei kann das Bauteil auf eine Temperatur erwärmt werden, die während des gesamten Polungsprozesses unter der Curietemperatur der Piezokeramik liegt. Zur teilweisen Polarisierung kann das Bauteil aber auch über die Curie-Temperatur der Piezokeramik erwärmt werden. Während eines Abkühlens des Bauteils auf Raumtemperatur wird dann ein Polarisationsfeld mit relativ geringer Feldstärke angelegt. Die Feldstärke dieses Polarisationsfeldes beträgt beispielsweise unter 100 V/mm.

Zur teilweisen Polarisierung der Piezokeramik kann auch zusätzlich eine mechanische Druckspannung auf die Piezokeramik der Bauteile ausgeübt werden. Es findet ein Druckpolarisieren statt. Die angelegte Druckspannung kann dabei über der Druckspannung liegen, unter der das Bauteil möglicherweise später betrieben wird. Beispielsweise wird bei einem Aktorkörper in monolithischer Vielschichtbauweise während des Polens des Bauteils ein Duck von 10 MPa bis 20 MPa angelegt.

Bei einem schwach gepolten Bauteil kann zum Herstellen der Korrelation auf die oben angegebenen, zu bestimmenden physikalischen Messgrößen zurückgegriffen werden. Insbesondere kann zur Bestimmung der morphotropen Phasengrenze und damit zum Herstellen der Korrelation eine relative Permittivität der Piezokeramik vor dem schwachen Polen (εᵣᵥ) und eine relative Permittivität der Piezokeramik nach dem schwachen Polen (εᵣₙ) bestimmt werden. Die relative Änderung der Permittivität ((εᵣₙ - εᵣᵥ)/εᵣᵥ) ist ein Maß für das Verhältnis der Volumenanteile der rhomboedrischen Phase und der tetragonalen Phase. Die Feldabhängigkeit der Polarisaionsladung (P(E)) und die maximale Polarisation Pₘₐₓ führen ebenfalls zu einer verwertbaren Korrelation zwischen Ausgangszustand und Polungszustand des Bauteils.

Im Übrigen sei noch angemerkt, dass durch die beschriebene, schwache Polung des Bauteils keinerlei Nachteile in Kauf genommen werden müssen. Wie bereits angegeben, wird die Polung so gestaltet, dass keine Schädigung des Bauteils auftritt. Darüber hinaus kann das schwach gepolte piezoelektrische Bauteil zur Weiterverarbeitung in einen ungepolten Zustand durch bekannte Verfahren überführt werden. So kann das schwach gepolte Bauteil durch Erwärmung über die Curietemperatur oder durch Anlegen eines Wechselfeldes mit zeitlich abnehmender Amplitude depolarisiert werden.

Bezüglich der Verwendung der Korrelation wird vorzugsweise aufgrund der Vorhersagemöglichkeit eine Qualität des Bauteils beurteilt. Weiterhin wird die Korrelation zur Gestaltung eines Polarisationsverfahrens verwendet, mit dem die Piezokeramik des Bauteils polarisiert wird, so dass ein Bauteil mit einem bestimmten zweiten Zustand erhalten wird. Aufgrund der bestimmten Eigenschaften des Bauteils und aufgrund der ermittelten Korrelation ergeben sich Hinweise darauf, wie das Polarisationsverfahren gestaltet werden muss, damit ein funktionsfähiges Bauteil erhalten wird. Beispielsweise werden Informationen darüber erhalten, dass das Bauteil unter einer bestimmten Druckspannung polarisiert werden sollte.

Wie bereits erwähnt, können beliebige piezoelektrische Bauteile verwendet werden. Vorzugsweise wird ein piezoelektrisches Bauteil verwendet, das mindestens ein Piezoelement mit mindestens zwei übereinander angeordneten Elektrodenschichten und mindestens einer zwischen den Elektrodenschichten angeordneten piezoelektrischen Schicht mit der Piezokeramik aufweist. Gemäß einer besonderen Ausgestaltung wird als piezoelektrisches Bauteil ein Vielschichtaktor verwendet, bei dem eine Vielzahl von Piezoelementen zu einem stapelförmigen Aktorkörper angeordnet sind.

Zusammenfassend ergeben sich mit der vorliegenden Erfindung folgende wesentlichen Vorteile:
- Mit der Erfindung ist es möglich, in einem frühen Stadium der Herstellung eines piezoelektrischen Bauteils, das eine Piezokeramik aufweist, dessen piezoelektrische Eigenschaften und damit dessen Qualität nach dem Polarisieren der Piezokeramik abzuschätzen. Bauteile, die mit großer Wahrscheinlichkeit nicht die geforderten piezoelektrischen Kenngrößen erzielen, können von der Weiterverarbeitung ausgeschlossen werden. Dies führt zu einer deutlichen Reduzierung der Herstellkosten.
- Mit der Erfindung kann eine definierte Schnittstelle zwischen Bauteile-Hersteller und Bauteile-Verarbeiter (Systemanwender) installiert werden. Der Systemanwender wird mit einem Halbzeug beliefert, also einem nicht fertigen Bauteil. Das nicht fertige Bauteil ist beispielsweise ein sogenannter "nackter Stack", also ein gesinterter, ungepolter Aktorkörper in monolithischer Vielschichtbauweise, bei dem lediglich die streifenförmigen Metallisierungen angebracht sind. Ein solcher Aktorkörper wird mit Hilfe der Erfindung charakterisiert.
- Die gemäß dem Verfahren zum Herstellen der Korrelation und später am einzelnen Bauteil zu bestimmenden physikalischen Eigenschaften sind einfach zu bestimmen.

Anhand mehrerer Beispiele und der dazugehörigen Figuren wird die Erfindung im Folgenden näher beschrieben. Die Figuren sind schematisch und stellen keine maßstabsgetreuen Abbildungen dar.
- Figur 1: zeigt ein Verfahren zum Herstellen der Korrelation.
- Figur 2: zeigt einen Querschnitt eines piezoelektrischen Bauteils in Form eines Piezoaktors mit einem Aktorkörper in monolithischer Vielschichtbauweise.
- Figur 3: zeigt ein Piezoelement des Piezoaktors aus Figur 2 in einem seitlichen Querschnitt.

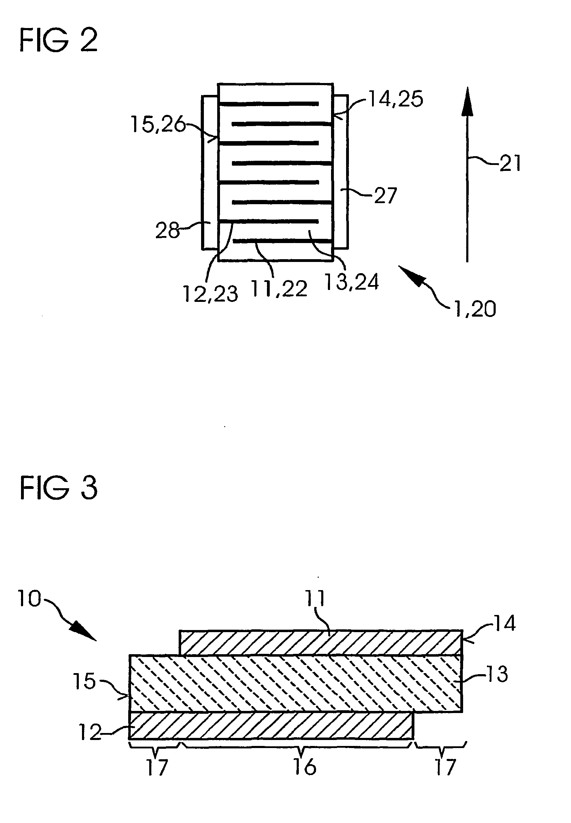

Das piezoelektrische Bauteil 1 ist ein Piezoaktor mit einem Aktorkörper 20 in monolithischer Vielschichtbauweise mit einer (nicht zu sehenden) quadratischen Grundfläche (Figur 2). Bei diesem Aktorkörper 20 ist eine Vielzahl von Piezoelementen entlang der Stapelrichtung 21 des Aktorkörpers 20 übereinander gestapelt und fest verbunden. Ingesamt ist der Aktorkörper aus bis zu 1000 einzelnen Schichten aufgebaut. Dabei weist ein einzelnes Piezoelement 10 eine piezoelektrische Schicht 13 aus einer Piezokeramik auf (Figur 3). Die Schichtdicke der piezoelektrischen Schicht 13 beträgt 20 µm bis 200 µm. Die Piezokeramik ist ein PZT. Die piezoelektrische Schicht 13 des Piezoelements 10 befindet sich zwischen einer Elektrodenschicht 11 und einer weiteren Elektrodenschicht 12 des Piezoelements 10. Das Elektrodenmaterial der Elektrodenschichten 11 und 12 ist eine Silber-Palladium-Legierung. Die Schichtdicke der Elektrodenschicht beträgt 1 µm bis 3 µm. Die Elektrodenschichten 11 und 12 sind derart an den Hauptflächen der piezoelektrischen Schicht 13 angeordnet, dass durch die elektrische Ansteuerung der Elektrodenschichten 11 und 12 ein elektrisches Feld in der piezoelektrischen Schicht 13 erzeugt wird. Dieses elektrische Feld kann während der Polung des Aktorkörpers als Polarisationsfeld fungieren und die Polarisation der Piezokeramik bewirken. Im Betrieb des Piezoaktors 1 führt das elektrische Feld in Verbindung mit der Polarisation der Piezokeramik zu einer bestimmten Auslenkung der piezoelektrischen Schicht 13 und damit zu einer bestimmten Auslenkung des Piezoelements 10.

Zur elektrischen Kontaktierung sind die Elektrodenschichten 11 und 12 an zwei, elektrisch voneinander isolierte Oberflächenabschnitte 14 und 15 geführt. An diesen Stellen sind die beiden Elektrodenschichten 11 und 12 jeweils mit einem (in Figur 3) nicht dargestellten elektrischen Anschlusselement verbunden. Durch die Führung der Elektroden 11 und 12 an unterschiedliche Oberflächenabschnitte 14 und 15 verfügt jedes Piezoelement 10 über einen piezoelektrisch aktiven Bereich 16 und mindestens zwei piezoelektrisch inaktive Bereiche 17.

Dadurch, dass bei dem Aktorkörper 20 in monolithischer Vielschichtbauweise eine Vielzahl von Piezoelementen 10 übereinander gestapelt sind, kann ein relativ hoher, absoluter Hub entlang der Stapelrichtung 21 des Aktorkörpers 20 bei einer relativ niedrigen Ansteuerspannung erzielt werden.

Benachbarte Piezoelemente 10 weisen jeweils eine gemeinsame Elektrodenschicht auf, so dass im Aktorkörper 20 Elektrodenschichten 22, 23 und piezoelektrische Schichten 24 abwechselnd übereinander angeordnet sind.

Die Elektrodenschichten 22 und 23 des Aktorkörpers 20 sind an zwei elektrisch voneinander isolierte, seitliche Oberflächenabschnitte 25 und 26 geführt. Die Oberflächenabschnitte 25 und 26 befinden sich an den Ecken des Aktorkörpers 20. Zum Herstellen des Aktorkörpers 20 werden keramische Grünfolien mit quadratischen Grundflächen verwendet, die an jeweils einer Ecke frei von Elektrodenmaterial sind, entsprechend übereinander gestapelt und gemeinsam gesintert. An den beiden Oberflächenabschnitten 25 und 26 wird jeweils eine streifenförmige Metallisierung 27 und 28 aufgetragen, so dass die Elektrodenschichten 23 und 24 abwechselnd elektrisch kontaktiert sind. Der so erhaltene Aktorkörper 20 wird als "nackter Stack" bezeichnet.

Gemäß dem Verfahren wird eine Korrelation zwischen einem ersten Zustand und einem zweiten Zustand des Aktorkörpers 20 hergestellt. Der erste Zustand des Aktorkörpers 20 entspricht dem Zustand nach dem Auftragen der Metallisierungen 27 und 28 an den Oberflächenabschnitten 25 und 26 des Aktorkörpers 20. Der Aktorkörper 20 ist dabei gemäß einem ersten Ausführungsbeispiel ungepolt. In einem dazu alternativen Ausführungsbeispiel der Aktorkörper 2 im ersten Zustand schwach gepolt. Der zweite Zustand ist in beiden Fällen der Polungszustand des Aktorkörpers 20, unter dem der Aktorkörper 20 betrieben wird.

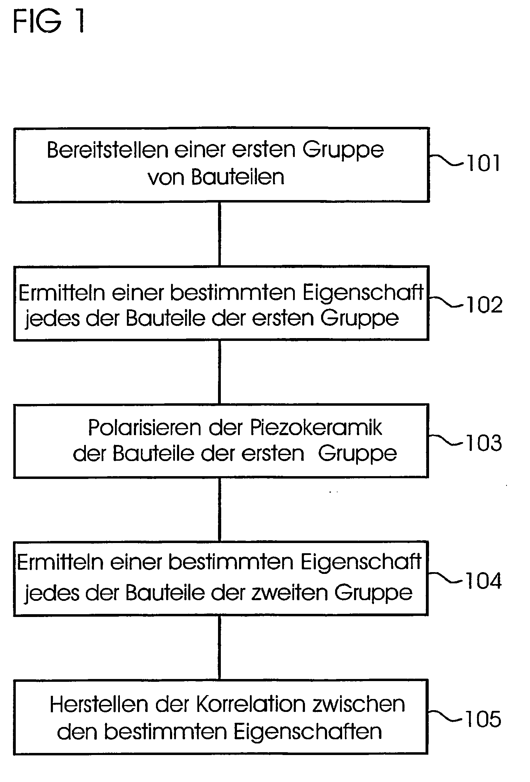

Zur Herstellung der Korrelation wird zunächst eine Anzahl solcher Aktorkörper 20 bereitgestellt (Figur 1, 101). Im Folgenden werden an jedem der Aktorkörper 20 mehrere bestimmte physikalische Eigenschaften ermittelt (Figur 1, 102). Dazu zählen die Dichte der Piezokeramik, der Temperaturgang der Kapazität des Aktorkörpers 20 und ferroelastische Eigenschaften des Aktorkörpers 20. Diese Eigenschaften können zum Bestimmen einer weiteren Eigenschaft herangezogen werden, nämlich zum Bestimmen der morphotropen Phasengrenze des PZTs.

Nach dem Ermitteln der Eigenschaft bzw. der Eigenschaften jedes der Aktorkörper 20 werden die Aktorkörper 20 gepolt durch Anlegen entsprechender Polarisationsfelder. Das PZT der piezoelektrischen Schichten 24 wird polarisiert (Figur 1, 103). Das Polen erfolgt dabei unter einer Druckspannung, die am Aktorkörper 20 so angelegt wird, dass sie der verlängernden Wirkung des Polarisationsfeldes entgegenwirkt.

Im weiteren Verlauf werden die piezoelektrischen Eigenschaften jedes der gepolten Aktorkörper 20 ermittelt (Figur 1, 104) und in Beziehung zu den ermittelten Eigenschaften des jeweiligen ungepolten Aktorkörpers 20 gesetzt (Figur 1, 105). Aus dem Vergleich der festgestellten, einzelnen Beziehungen wird die, für die Art des Aktorkörpers 20 gültige Korrelation zwischen dem Ausgangszustand des Aktorkörpers 20 und dem Polungszustand des Aktorkörpers 20 hergestellt.

Die so hergestellte Korrelation wird zur Charakterisierung eines Aktorkörpers 20 benutzt. Der Aktorkörper 20 wird im Ausgangszustand, also in dem Zustand nach dem Anbringen der Metallisierungen (ungepolt oder schwach gepolt) vermessen. Es wird die für die Korrelation verwendete Eigenschaft bzw. es werden die für die Korrelation verwendeten Eigenschaften ermittelt. Aus den daraus gewonnen Daten lässt sich eine Wahrscheinlichkeit dafür abschätzen, dass der Aktorkörper 20 nach dem Polen (inkl. weiterer Verarbeitungsschritte) piezoelektrische Kenngrößen aufweist, die in einem festgelegten Toleranzbereich liegen. Anhand dieser Abschätzung wird der Aktorkörper 20 entweder der weiteren Verarbeitung zugeführt oder von der weiteren Verarbeitung ausgeschlossen.

## Patentansprüche

1. Verfahren zum Herstellen einer Korrelation zwischen einem ersten Zustand eines piezoelektrischen Bauteils (1, 20), das eine Piezokeramik aufweist, und einem zweiten Zustand des Bauteils, wobei der zweite Zustand des Bauteils aus dem ersten Zustand des Bauteils durch ein Polarisieren der Piezokeramik des Bauteils erzeugt wird, mit folgenden Verfahrensschritten:
a) Bereitstellen einer ersten Gruppe von Bauteilen mit jeweils dem ersten Zustand,
b) Ermitteln mindestens einer bestimmten Eigenschaft jedes der Bauteile der ersten Gruppe,
c) Polarisieren der Piezokeramik der Bauteile der ersten Gruppe, wobei aus jedem der Bauteile der ersten Gruppe ein entsprechendes Bauteil einer zweiten Gruppe entsteht, das den zweiten Zustand aufweist,
d) Ermitteln mindestens einer bestimmten Eigenschaft jedes der Bauteile der zweiten Gruppe und
e) Herstellen der Korrelation durch Vergleich der bestimmten Eigenschaft jedes der Bauteile der ersten Gruppe und der bestimmten Eigenschaft des entsprechenden Bauteils der zweiten Gruppe, **dadurch gekennzeichnet, dass**
f) die bestimmte Eigenschaft des Bauteils mit dem ersten Zustand aus der Gruppe Verlustwinkel der piezoelektrischen Schicht, Isolationswiderstand der piezoelektrischen Schicht, Dichte der piezoelektrischen Schicht, relative Permittivität der piezoelektrischen Schicht, ferroelastisches Verhalten des Bauteils, Elastizitätsmodul des Bauteils, longitudinale Schallgeschwindigkeit des Bauteils und/oder Temperaturgang der Kapazität des Bauteils ausgewählt wird.

2. Verfahren nach Anspruch 1, wobei eine Anzahl von bestimmten Eigenschaften des Bauteils mit dem ersten Zustand ermittelt wird und zum Herstellen der Korrelation mit der bestimmten Eigenschaft des Bauteils mit dem zweiten Zustand verwendet wird.

3. Verfahren nach einem der Ansprüche 1 oder 2, wobei als Piezokeramik ein Bleizirkonattitanat verwendet wird.

4. Verfahren nach Anspruch 3, wobei als bestimmte Eigenschaft des Bauteils mit dem ersten Zustand ein Verhältnis eines rhomboedrischen Volumenanteils mit rhomboedrischer Phase und eines tetragonalen Volumenanteils mit tetragonaler Phase verwendet wird.

5. Verfahren nach einem der Ansprüche 1 bis 4, wobei Bauteile der ersten Gruppe verwendet werden, deren erster Zustand sich jeweils durch eine teilweise Polarisierung der Piezokeramik auszeichnet.

6. Verfahren nach Anspruch 5,wobei zur teilweisen Polarisierung die Piezokeramik der Bauteile bei Raumtemperatur druckfrei polarisiert wird.

7. Verfahren nach Anspruch 5 oder 6, wobei zur teilweisen Polarisierung die Piezokeramik der Bauteile bei einer Polungstemperatur polarisiert wird, die höher ist als die Raumtemperatur.

8. Verfahren nach einem der Ansprüche 5 bis 7, wobei zur teilweisen Polarisierung eine mechanische Druckspannung auf die Piezokeramik der Bauteile ausgeübt wird.

9. Verfahren nach einem der Ansprüche 5 bis 8, wobei zur teilweisen Polarisierung das Bauteil über die Curietemperatur der Piezokeramik erwärmt wird und während eines Abkühlens des Bauteils auf Raumtemperatur ein Polarisationsfeld mit geringer Feldstärke von unter 100V/mm angelegt wird.

10. Verfahren nach einem der Ansprüche 1 bis 9, wobei ein piezoelektrisches Bauteil verwendet wird, das mindestens ein Piezoelement (10) mit mindestens zwei übereinander angeordneten Elektrodenschichten (11, 12) und mindestens einer zwischen den Elektrodenschichten angeordneten piezoelektrischen Schicht (13) mit der Piezokeramik aufweist.

11. Verfahren nach Anspruch 10, wobei als piezoelektrisches Bauteil ein Vielschichtaktor verwendet wird, bei dem eine Vielzahl von Piezoelementen (10) zu einem stapelförmigen Aktorkörper (20) angeordnet sind.

12. Verwendung einer nach einem der Ansprüche 1 bis 11 hergestellten Korrelation zur Vorhersage der bestimmten Eigenschaft eines bestimmten piezoelektrischen Bauteils mit dem zweiten Zustand aus der ermittelten bestimmten Eigenschaft des bestimmten Bauteils mit dem ersten Zustand.

13. Verwendung nach Anspruch 12, wobei aufgrund der Vorhersage eine Qualität des Bauteils beurteilt wird.

14. Verwendung einer nach einem der Ansprüche 1 bis 11 hergestellten Korrelation zur Gestaltung eines Polarisätionsverfahrens, mit dem die Piezokeramik des Bauteils polarisiert wird, so dass ein Bauteil mit einem bestimmten zweiten Zustand erhalten wird.

## Claims

1. Method for establishing a correlation between a first state of a piezoelectric component (1, 20) having a piezoceramic element and a second state of the component, the second state of the component being generated from the first state of the component by polarisation of the piezoceramic element of the component, with the following method steps:
a) provision of a first group of components each with the first state,
b) determination of at least one specific characteristic of each of the components of the first group,
c) polarisation of the piezoceramic element of the components of the first group, with a corresponding component of a second group resulting from each of the components of the first group and having the second state,
d) determination of at least one specific characteristic of each of the components of the second group and
e) establishment of the correlation by comparing the specific characteristic of each of the components of the first group and the specific characteristic of the corresponding component of the second group, **characterised in that**
f) the specific characteristic of the component with the first state is selected from the group loss angle of the piezoelectric layer, insulation resistance of the piezoelectric layer, density of the piezoelectric layer, relative permittivity of the piezoelectric layer, ferroelastic behaviour of the component, module of elasticity of the component, longitudinal sound velocity of the component and/or temperature sensitivity of the capacity of the component.

2. Method according to claim 1, in which a number of specific characteristics of the component with the first state is determined and used to establish the correlation with the specific characteristic of the component with the second state.

3. Method according to one of claims 1 to 2, with a lead zirconate titanate being used as the piezoceramic element.

4. Method according to claim 3, with a ratio of a rhombohedric part by volume with a rhombohedric phase and a tetragonal part by volume with a tetragonal phase being used as the specific characteristic of the component with the first state.

5. Method according to one of claims 1 to 4, with components of the first group being used, the first state of which is **characterised by** partial polarisation of the piezoceramic element in each instance.

6. Method according to claim 5, in which for the purposes of partial polarisation the piezoceramic element of the components is polarised without pressure at room temperature.

7. Method according to claim 5 or 6, in which for the purposes of partial polarisation the piezoceramic element of the components is polarised at a poling temperature that is higher than room temperature.

8. Method according to one of claims 5 to 7, in which for the purposes of partial polarisation a mechanical compressive stress is exerted on the piezoceramic element of the components.

9. Method according to one of claims 5 to 8, in which for the purposes of partial polarisation the component is heated to above the Curie temperature of the piezoceramic element and a polarisation field with a low field strength of less than 100 V/mm is applied as the component cools to room temperature.

10. Method according to one of claims 1 to 9, with a piezoelectric component being used, which has at least one piezoelement (10) with at least two electrode layers (11, 12) arranged one on top of the other and at least one piezoelectric layer (13), containing the piezoceramic element, arranged between the electrode layers.

11. Method according to claim 10, with a multilayer actuator being used as the piezoelectric component, in which a number of piezoelements (10) are arranged to form a stacked actuator body (20).

12. Use of the correlation established according to one of claims 1 to 11 to predict the specific characteristic of a specific piezoelectric component with the second state from the determined specific characteristic of the specific component with the first state.

13. Use according to claim 12, with a quality of the component being judged based on the prediction.

14. Use of a correlation established according to one of claims 1 to 11 to configure a polarisation method, with which the piezoceramic element of the component is polarised, such that a component with a specific second state is obtained.

## Revendications

1. Procédé pour établir une corrélation entre un premier état d'un composant piézoélectrique (1, 20) comportant une céramique piézoélectrique, et un deuxième état du composant, le deuxième état du composant étant engendré à partir du premier état du composant par une polarisation de la céramique piézoélectrique du composant, ce procédé présentant les étapes de procédé suivantes :
a) mettre à disposition un premier groupe de composants se trouvant chacun dans le premier état,
b) établir au moins une propriété déterminée de chaque composant du premier groupe,
c) polariser la céramique piézoélectrique des composants du premier groupe, ce qui provoque la formation à partir de chaque composant du premier groupe un composant correspondant d'un deuxième groupe qui présente le deuxième état,
d) établir au moins une propriété déterminée de chaque composant du deuxième groupe et
e) établir la corrélation au moyen d'une comparaison entre la propriété déterminée de chaque composant du premier groupe et la propriété déterminée du composant correspondant du deuxième groupe, **caractérisé en ce que**
f) la propriété déterminée du composant présentant le premier état est choisie dans le groupe formé de l'angle de perte de la couche piézoélectrique, de la résistance d'isolation de la couche piézoélectrique, de la densité de la couche piézoélectrique, de la permittivité relative de la couche piézoélectrique, du comportement ferroélastique du composant, du module d'élasticité du composant, de la vitesse acoustique longitudinale du composant et/ou du comportement thermique de la capacité du composant.

2. Procédé selon la revendication 1, au cours duquel on établit un certain nombre de propriétés déterminées du composant présentant le premier état et on utilise ce certain nombre de propriétés déterminées pour établir la corrélation, avec la propriété déterminée du composant présentant le deuxième état.

3. Procédé selon la revendication 1 ou 2, au cours duquel on utilise comme céramique piézoélectrique un titanate de plomb et de zirconium.

4. Procédé selon la revendication 3, au cours duquel comme propriété déterminée du composant présentant le premier état, on utilise un rapport entre une fraction volumique rhomboédrique présentant une phase rhomboédrique et une fraction volumique tétragonale présentant une phase tétragonale.

5. Procédé selon l'une des revendications 1 à 4, au cours duquel on utilise des composants du premier groupe dont le premier état se distingue respectivement par une polarisation partielle de la céramique piézoélectrique.

6. Procédé selon la revendication 5, au cours duquel, en vue de la polarisation partielle, la céramique piézoélectrique des composants est polarisée à température ambiante en l'absence de pression.

7. Procédé selon la revendication 5 ou 6, au cours duquel, en vue de la polarisation partielle, la céramique piézoélectrique des composants est polarisée à une température de polarisation supérieure à la température ambiante.

8. Procédé selon l'une des revendications 5 à 7, au cours duquel, en vue de la polarisation partielle, on exerce sur la céramique piézoélectrique des composants une tension de compression mécanique.

9. Procédé selon l'une des revendications 5 à 8, au cours duquel, en vue de la polarisation partielle, le composant est chauffé au dessus de la température de Curie de la céramique piézoélectrique et on applique un champ de polarisation avec une faible intensité de champ inférieure à 100V/mm pendant le refroidissement du composant jusqu'à la température ambiante.

10. Procédé selon l'une des revendications 1 à 9, au cours duquel on utilise un composant piézoélectrique comportant au moins un élément piézoélectrique (10) comprenant au moins au moins deux couches d'électrode superposées (11, 12) et au moins une couche piézoélectrique (13) comprenant de la céramique piézoélectrique et disposée entre les couches d'électrode.

11. Procédé selon la revendication 10, au cours duquel, en tant que composant piézoélectrique, on utilise un actionneur multi-couches dans lequel une pluralité d'éléments piézoélectriques (10) est agencée pour constituer un corps d'actionneur (20) en forme d'empilement.

12. Utilisation d'une corrélation établie selon l'une des revendications 1 à 11 en vue de la prédiction de la propriété déterminée d'un composant piézoélectrique déterminé présentant le deuxième état à partir de la propriété déterminée établie du composant déterminé présentant le premier état.

13. Utilisation selon la revendication 12, dans laquelle on juge de la qualité du composant sur la base de la prédiction.

14. Utilisation d'une corrélation établie selon l'une des revendication 1 à 11 en vue de la conception d'un procédé de polarisation au moyen duquel on polarise la céramique piézoélectrique du composant afin d'obtenir un composant présentant un deuxième état déterminé.
